# EUROPEAN PATENT APPLICATION

(11) **EP 4 701 287 A1**
(43) Date of publication of application: **25.02.2026**
(21) Application number: 24818413.7
(22) Date of filing: 28.04.2024
(51) Int. Cl.: H04W 52/52

(54) **ADAPTIVE GAIN CONTROL METHOD AND APPARATUS, STORAGE MEDIUM, AND ELECTRONIC APPARATUS**

(30) Priority: 09.06.2023 CN 202310685139
(71) Applicant: ZTE CORPORATION, Shenzhen, Guangdong 518057 (CN)
(72) Inventor: WANG, Xiaomei, Shenzhen, Guangdong 518057 (CN)
(74) Representative: Chimini, Francesco
(86) International application number: PCT/CN2024/090424
(87) International publication number: WO 2024/250879

(57) **Abstract**

Embodiments of the present disclosure provide an adaptive gain control method and apparatus, a storage medium, and an electronic apparatus. Signals from second user equipment and third user equipment are received by means of first user equipment. The first user equipment uses a first subcarrier spacing and a first-type service scheduling unit to communicate with the second user equipment, and the first user equipment uses a second subcarrier spacing and a second-type service scheduling unit to communicate with the third user equipment. The signals comprise the first-type service scheduling unit and the second-type service scheduling unit. The first user equipment performs adaptive gain control on the signals one or more times.

## Description

### Cross-Reference to Related Application

The present application is based on and claims priority to Chinese patent application CN202310685139.3 filed on June 09, 2023 and entitled "Adaptive Gain Control Method and Apparatus, Storage Medium, and Electronic Apparatus", the disclosure of which is incorporated herein by reference in its entirety.

### Technical Field

Embodiments of the present disclosure relate to the field of communications, and in particular, to an adaptive gain control method and apparatus, a storage medium, and an electronic apparatus.

### Background

In a Long Term Evolution (LTE) system, also known as the Fourth Generation Mobile Communications Technology (4G) system, only a Sub-Carrier Spacing (SCS) of 15 kHz is supported, and correspondingly, a time length of one LTE Subframe (SF) is 1 ms, wherein the 1 ms time length includes 14 LTE Orthogonal Frequency Division Multiplexing (OFDM) symbols. In a New Radio (NR) system, also known as the Fifth Generation Mobile Communications Technology (5G) system, to overcome the Doppler frequency shift effects of higher mobile speeds, a larger SCS is supported, such as 30 kHz. Since the SCS and the time length of one OFDM are inversely proportional, this also means that when the SCS is 30 kHz, the time length of one NR OFDM is halved compared to that of the LTE OFDM, resulting in a change to a 0.5 ms time length for one NR SF, wherein the 0.5 ms time length includes 14 NR OFDM symbols. One SF can be considered as one service scheduling unit.

In the current system, the demand for direct communication between User Equipment (UE) devices is increasingly strong, such as in gaming, convoys, group scenarios, etc. When receiving, UE often needs to perform Automatic Gain Control (AGC) operations, which means that the power of a received signal first needs to be adjusted to a reasonable range to avoid saturation of a Analog-to-Digital Converter (ADC) and the resulting quantization errors. The adjusted receive gain remains constant throughout the entire SF time length. When a UE communicates with a UE from a different system, due to the different sub-carrier spacings, the time lengths of service scheduling units of different systems are different, and it is not guaranteed that the receive gain adjusted in the front segment is suitable for the latter segment data of the LTE SF, which is called AGC mismatch, meaning there is a quantization error in the latter segment data of the LTE SF.

### Summary

The embodiments of the present disclosure provide an adaptive gain control method and apparatus, a storage medium, and an electronic apparatus.

According to an embodiment of the present disclosure, an adaptive gain control method is provided, including: receiving, by a first user equipment, a signal from a second user equipment and a third user equipment, wherein the first user equipment communicates with the second user equipment using a first sub-carrier spacing and a first-type service scheduling unit, and the first user equipment communicates with the third user equipment using a second sub-carrier spacing and a second-type service scheduling unit, and the signal includes the first-type service scheduling unit and the second-type service scheduling unit; and performing, by the first user equipment, one or multiple adaptive gain controls on the signal.

According to another embodiment of the present disclosure, an adaptive gain control apparatus provided in a first user equipment is provided, the adaptive gain control apparatus including: a communication module, configured to receive a signal from a second user equipment and a third user equipment, wherein the first user equipment communicates with the second user equipment using a first sub-carrier spacing and a first-type service scheduling unit, and the first user equipment communicates with the third user equipment using a second sub-carrier spacing and a second-type service scheduling unit, and the signal includes the first-type service scheduling unit and the second-type service scheduling unit; and a control module, configured to perform one or multiple adaptive gain controls on the signal.

According to another embodiment of the present disclosure, a computer-readable storage medium is also provided. The computer-readable storage medium stores a computer program, and the computer program, when executed by a processor, causes the processor to implement the operations in any one of the method embodiments.

According to another embodiment of the present disclosure, also provided is an electronic apparatus, including a memory and a processor, wherein the memory stores a computer program, and the processor is configured to run the computer program so as to execute the operations in any one of the method embodiments.

### Brief Description of the Drawings

Fig. 1 is a schematic diagram of AGC mismatch in the related art;
Fig. 2 is a schematic diagram of AGC mismatch in the related art;
Fig. 3 is a block diagram of a hardware structure of a computer terminal for implementing an adaptive gain control method according to an embodiment of the present disclosure;
Fig. 4 is a flowchart of an adaptive gain control method according to an embodiment of the present disclosure;
Fig. 5 is a structure block diagram of an adaptive gain control apparatus according to an embodiment of the present disclosure;
Fig. 6 is a structure block diagram of an adaptive gain control apparatus according to an embodiment of the present disclosure;
Fig. 7 is a flowchart illustrating the principle of an adaptive gain control method according to an embodiment of the present disclosure;
Fig. 8 is a schematic diagram of AGC adjustment according to an embodiment of the present disclosure;
Fig. 9 is a schematic diagram of AGC adjustment according to an embodiment of the present disclosure;
Fig. 10 is a schematic diagram of AGC adjustment according to an embodiment of the present disclosure;
Fig. 11 is a schematic diagram of AGC adjustment according to an embodiment of the present disclosure; and
Fig. 12 is a schematic diagram of AGC adjustment according to an embodiment of the present disclosure.

### Detailed Description of the Embodiments

Hereinafter, the embodiments of the present disclosure will be described in detail with reference to the accompanying drawings and embodiments.

It should be noted that terms such as "first" and "second" in the description and claims of the embodiments of the present disclosure and the drawings are used to distinguish similar objects, and are not necessarily used to describe a specific sequence or order.

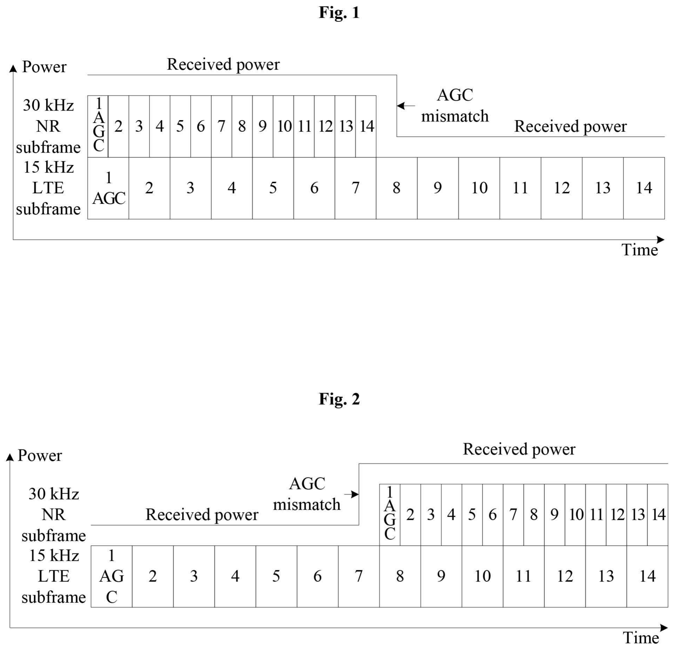

When UE1 communicates only with UE2, or when UE1 communicates simultaneously with LTE UE3 and LTE UE4, where both UE3 and UE4 are LTE UEs, UE3 and UE4 have the same sub-carrier spacing, hence the service scheduling units have equal time lengths, this means that the received power within the time range of the service scheduling units remains constant, that is, AGC is not required within the time range of the service scheduling units. However, when UE1 communicates simultaneously with LTE UE3 and NR UE4, due to the different sub-carrier spacings used by LTE and NR, the LTE service scheduling unit and the NR service scheduling unit have different time lengths, it cannot be ensured that the receive gain adjusted in the front segment is suitable for the latter segment data of the LTE subframe, which is known as AGC mismatch. Fig. 1 is a schematic diagram of AGC mismatch in the related art. As shown in Fig. 1, the received power for the latter segment data of the LTE subframe is too low, leading to quantization errors. Fig. 2 is a schematic diagram of AGC mismatch in the related art. As shown in Fig. 2, the received power for the latter segment data of the LTE subframe is too high, leading to quantization errors.

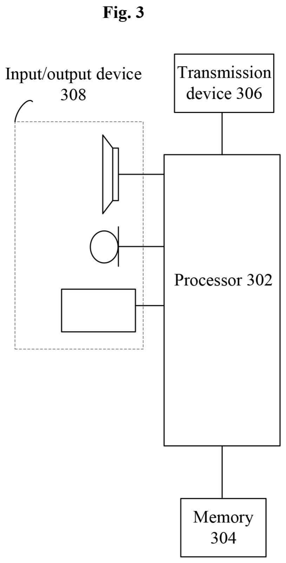

The method embodiments provided in the embodiments of the present disclosure may be executed in a mobile terminal, a computer terminal or a similar computing device. Taking the running on a computer terminal as an example, Fig. 3 is a block diagram of a hardware structure of a computer terminal for implementing an adaptive gain control method according to an embodiment of the present disclosure. As shown in Fig. 3, the computer terminal may include one or more processors 302 (only one is shown in Fig. 3) (the one or more processors 302 may include but are not limited to a processing apparatus such as a microprocessor (e.g., Micro-Controller Unit (MCU)) or a programmable logic device (e.g., a Field Programmable Gate Array (FPGA))) and a memory 304 configured to store data. The computer terminal may further include a transmission device 306 for a communication function and an input/output device 308. Those having ordinary skill in the art may understand that the structure shown in Fig. 3 is merely exemplary, which does not limit the structure of the foregoing computer terminal. For example, the computer terminal may further include more or fewer components than shown in Fig. 3, or have a different configuration from that shown in Fig. 3.

The memory 304 may be configured to store a computer program, for example, a software program and a module of application software, such as a computer program corresponding to the adaptive gain control method in the embodiments of the present disclosure. The one or more processors 302 run the computer program stored in the memory 304, so as to execute various function applications and data processing, that is, to implement the foregoing methods. The memory 304 may include a high-speed random access memory, and may also include a non-volatile memory, such as one or more magnetic storage devices, flash memory, or other non-volatile solid-state memory. In some embodiments, the memory 304 may further include a memory remotely located with respect to the one or more processors 302, which may be connected to the computer terminal over a network. Examples of such networks include, but are not limited to, the Internet, intranets, local area networks, mobile communication networks, and combinations thereof.

The transmission device 306 is configured to receive or transmit data via a network. The above-described network may include a wireless network provided by a communication provider of the computer terminal. In an embodiment, the transmission device 306 may include a Network Interface Controller (NIC) that may be coupled to other network devices via a base station to communicate with the Internet. In an embodiment, the transmission device 306 may be a Radio Frequency (RF) module that is used to wirelessly communicate with the Internet.

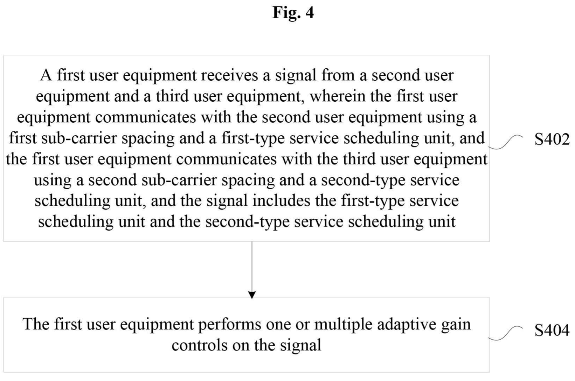

An embodiment of the present disclosure provides an adaptive gain control method running on the computer terminal. Fig. 4 is a flowchart of an adaptive gain control method according to an embodiment of the present disclosure. As shown in Fig. 4, the flow includes the following operations S402 and S404.

In operation S402, a first user equipment receives a signal from a second user equipment and a third user equipment, wherein the first user equipment communicates with the second user equipment using a first sub-carrier spacing and a first-type service scheduling unit, and the first user equipment communicates with the third user equipment using a second sub-carrier spacing and a second-type service scheduling unit, and the signal includes the first-type service scheduling unit and the second-type service scheduling unit.

In an exemplary embodiment, the second sub-carrier spacing is N times the first sub-carrier spacing, and a time length of the first-type service scheduling unit is N times a time length of the second-type service scheduling unit, wherein N is a positive integer.

In an actual implementation, when the first user equipment communicates with different user equipments, namely the aforementioned second user equipment and third user equipment, since the second user equipment and the third user equipment belong to different communication systems, for example, the second user equipment belongs to a 4G system, and the third user equipment belongs to a 5G system, the first user equipment will select different sub-carrier spacings and service scheduling units corresponding to the different communication systems when communicating with the second user equipment and the third user equipment. In the aforementioned communication process, the first user equipment acts as a receiving end, while the second user equipment and the third user equipment act as sending ends. For instance, the aforementioned first-type service scheduling unit may be an LTE service scheduling unit, and the second-type service scheduling unit may be an NR service scheduling unit, where the first sub-carrier spacing of the LTE service scheduling unit is 15 kHz, and the second sub-carrier spacing of the NR service scheduling unit is 30 kHz. Given that the Sub-Carrier Spacing (SCS) and the time length of the OFDM symbol are inversely proportional, the time length of the LTE service scheduling unit is twice that of the NR service scheduling unit, which means the time length of the first-type service scheduling unit is twice that of the second-type service scheduling unit, with N being equal to 2. In a practical implementation, if a larger SCS is needed to overcome related effects, such as a Doppler frequency shift, the frequency value of the second sub-carrier spacing may continue to increase, and the multiple N of the time length of the first-type service scheduling unit compared to the second-type service scheduling unit may also increase. The above implementation is provided as an illustrative example and not a specific limitation.

In operation S404, the first user equipment performs one or multiple adaptive gain controls on the signal.

In a practical implementation, the first user equipment may perform adaptive gain control once or multiple times (i.e., one or multiple adaptive gain controls) on the received signal according to an actual situation.

In an exemplary embodiment, before the first user equipment receives the signal from the second user equipment and the third user equipment, the adaptive gain control method may further include the following operation: the first user equipment receives a first notification message from the third user equipment, wherein the first notification message indicates whether the signal includes a long-format second-type service scheduling unit, wherein the long-format second-type service scheduling unit is formed by merging N second-type service scheduling units, and a time length of the long-format second-type service scheduling unit is equal in the time length of one first-type service scheduling unit.

In an actual implementation, if the second user equipment belongs to the 4G system and the third user equipment belongs to the 5G system, the time length of the LTE service scheduling unit is twice that of the NR service scheduling unit, meaning the time length of the first-type service scheduling unit is twice the time length of the second-type service scheduling unit, with N being equal to 2. Therefore, the long-format second-type service scheduling unit is formed by merging two second-type service scheduling units. In an embodiment, the long-format second-type service scheduling unit is obtained by merging two second-type service scheduling units, resulting in the same received power for the signal received by the first user equipment from the third user equipment, i.e., the NR service scheduling unit. Consequently, only one adaptive gain control is required at the frontmost position of the signal. Correspondingly, one adaptive gain control is also performed at the frontmost position of the signal from the second user equipment, i.e., the LTE service scheduling unit. That is, when the signal includes the long-format second-type service scheduling unit, the first user equipment performs one adaptive gain control at the frontmost position of the signal. This ensures that the total received power of the signal is within the quantization range of the ADC, where the quantization range of the ADC is determined by the AGC adjustment. As the receiving end, the first user equipment will first execute AGC control upon receiving the signal to ensure that the power of the received signal is within a reasonable range, i.e., the aforementioned quantization range of the ADC. This guarantees that the signals received by the first user equipment are all within the quantization range expected and adjusted by AGC, thereby minimizing or avoiding quantization errors in subsequent ADC operations.

For the embodiments of the present disclosure, when the signal includes a long-format second-type service scheduling unit, the first user equipment performs one adaptive gain control at the frontmost position of the signal. The second-type service scheduling units from the third user equipment are merged into a long-format second-type service scheduling unit, aligning the time length of the second-type service scheduling units with that of the first-type service scheduling units, and the received power of the second-type service scheduling units does not change. Therefore, by performing one adaptive gain control at the frontmost position of the signal, the quantization range of the received power of the entire signal, including both the first-type service scheduling unit and the second-type service scheduling unit, can be obtained. During subsequent signal reception, since the received power of the first-type service scheduling units and the second-type service scheduling units does not change, there is no need for further AGC adjustments, ensuring that the total received power remains within the ADC quantization range, meaning the received power of both the first-type service scheduling units and the second-type service scheduling units is constantly within the ADC quantization range.

In an exemplary embodiment, in a case where the signal does not include the long-format second-type service scheduling unit, the first user equipment performs adaptive gain controls at start positions of a first part and a second part of the first-type service scheduling unit in the signal, wherein the first-type service scheduling unit includes the first part and the second part, and a time length of the first part or the second part is equal to the time length of the second-type service scheduling unit.

In an actual implementation, when the second-type service scheduling units are not merged to obtain the long-format second-type service scheduling unit, after AGC adjustment is performed at the frontmost position of the first-type service scheduling unit, since the received power of the second-type service scheduling units received by the third user equipment for communication differs from the received power of the first-type service scheduling units received by the third user equipment for communication, separate AGC adjustments are required at the frontmost position of the second-type service scheduling units and at the corresponding position aligned with the frontmost position of the second-type service scheduling units in the first-type service scheduling units. This ensures that the total received power of the second-type service scheduling units and the first-type service scheduling units is within the quantization range of the ADC. The explanation of the quantization range of the ADC has been described in the preceding embodiments and will not be reiterated here. In an embodiment, due to the uncertainty of the reception time of the second-type service scheduling units, the alignment position between the second-type service scheduling units and the first-type service scheduling units is also uncertain. Therefore, the first part or the second part of the aforementioned first-type service scheduling unit is of equal length to the second-type service scheduling unit (aligned).

In an exemplary embodiment, the first notification message further includes an indication of whether powers of multiple second-type service scheduling units forming the long-format second-type service scheduling unit are the same.

Based on the first notification message which further includes an indication of whether powers of multiple second-type service scheduling units forming the long-format second-type service scheduling unit are the same, in an exemplary embodiment, in a case where the signal includes the long-format second-type service scheduling unit and the powers of the multiple second-type service scheduling units forming the long-format second-type service scheduling unit are different, the first user equipment performs one adaptive gain control at a frontmost position of the signal, and performs adaptive gain controls at positions where the first-type service scheduling unit and the second-type service scheduling unit with a different power are aligned. In an exemplary embodiment, in a case where the signal includes the long-format second-type service scheduling unit and powers of the multiple second-type service scheduling units forming the long-format second-type service scheduling unit are the same, the first user equipment performs one adaptive gain control at a frontmost position of the signal. In an actual implementation, in a case where the signal includes the long-format second-type service scheduling unit and powers of the multiple second-type service scheduling units forming the long-format second-type service scheduling unit are the same, the long-format second-type service scheduling unit may be formed by merging or may be inherent to the signal itself.

In an exemplary embodiment, the first notification message further indicates whether virtual data is filled in the long-format second-type service scheduling unit, a position of the virtual data, and a size of the virtual data.

In actual implementation, if the number of second-type service scheduling units from the third user equipment is not sufficient to support merging to obtain a long-format second-type service scheduling unit, meaning the amount of transmitted data from the third user equipment is not enough for merging to obtain a long-format second-type service scheduling unit, in order to acquire a long-format second-type service scheduling unit, it is suggested to fill virtual data within the long-format second-type service scheduling unit. Therefore, the first notification message further indicates whether virtual data is filled in the long-format second-type service scheduling unit, and the first notification message further indicates a position of the virtual data, and a size of the virtual data. The first user equipment performs one adaptive gain control at the frontmost position of the signal.

In actual implementation, the purpose of enabling the first notification message to indicate a position of the virtual data and a size of the virtual data is to enable recognition and extraction of the signal after the first user equipment has completed reception. Only after receiving the first notification message from the third user equipment, which also indicates the position of the virtual data and the size of the virtual data, can the first user equipment extract the virtual data of the corresponding size from the corresponding position of the long-format second-type service scheduling unit, thereby obtaining the original second-type service scheduling unit that needs to be transmitted and acquired.

Through the aforementioned operations, the first user equipment receives a signal from the second user equipment and the third user equipment, wherein the first user equipment communicates with the second user equipment using a first sub-carrier spacing and a first-type service scheduling unit, and the first user equipment communicates with the third user equipment using a second subcarrier spacing and a second-type service scheduling unit, and the signal includes the first-type service scheduling unit and the second-type service scheduling unit; and the first user equipment performs one or multiple adaptive gain controls on the signal. This solves the problem of quantization errors in automatic gain control of received signals in the related art and achieves the effect of reducing quantization errors when user equipment performs automatic gain control on received signals.

The executing entity of the aforementioned operations may be, but is not limited to, a base station, terminal, etc.

Through the description of the foregoing embodiments, those having ordinary skill in the art may clearly understand that the adaptive gain control method according to the foregoing embodiments may be implemented by software in addition to a necessary universal hardware platform, and definitely may also be implemented by hardware. However, in many cases, the former is a preferred implementation. Based on such understanding, the essence of the technical solutions of the embodiments of the present disclosure or the part contributing to the related art may be embodied in the form of a software product. The computer software product is stored in a storage medium (such as a Read-Only Memory (ROM)/Random Access Memory (RAM), a magnetic disk, and an optical disk), and includes several instructions for instructing a terminal device (which may be a mobile phone, a computer, a server, a network device, or the like).

An adaptive gain control apparatus is also provided in the embodiments of the present disclosure. The adaptive gain control apparatus is used for implementing the described embodiments and exemplary implementations, and what has been described will not be elaborated. The term "module", as used hereinafter, is a combination of software and/or hardware capable of realizing a predetermined function. Although the adaptive gain control apparatus described in the following embodiment is preferably implemented by software, implementation of hardware or a combination of software and hardware is also possible and conceived.

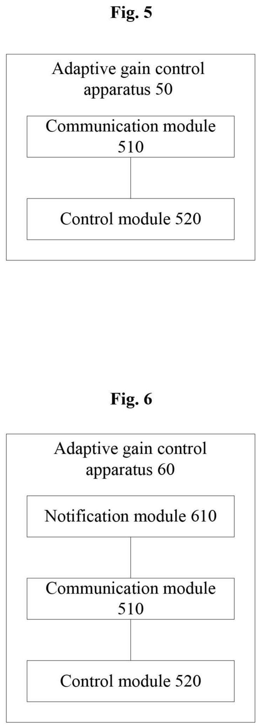

Fig. 5 is a structure block diagram of an adaptive gain control apparatus according to an embodiment of the present disclosure. As shown in Fig. 5, the adaptive gain control apparatus 50 includes: a communication module 510 configured to receive a signal from a second user equipment and a third user equipment, wherein the first user equipment communicates with the second user equipment using a first sub-carrier spacing and a first-type service scheduling unit, and the first user equipment communicates with the third user equipment using a second sub-carrier spacing and a second-type service scheduling unit, and the signal includes the first-type service scheduling unit and the second-type service scheduling unit; and a control module 520 configured to perform one or multiple adaptive gain controls on the signal.

Fig. 6 is a structure block diagram of an adaptive gain control apparatus according to an embodiment of the present disclosure. In an exemplary embodiment, as shown in Fig. 6, in addition to the modules in Fig. 5, the adaptive gain control apparatus 60 further includes a notification module 610 configured to receive a first notification message from the third user equipment, wherein the first notification message indicates whether the signal includes a long-format second-type service scheduling unit, wherein the long-format second-type service scheduling unit is formed by merging N second-type service scheduling units, and a time length of the long-format second-type service scheduling unit is equal in the time length of one first-type service scheduling unit.

In an exemplary embodiment, the control module 520 is configured to perform one adaptive gain control on the signal in the following manner: in a case where the signal includes the long-format second-type service scheduling unit, the control module 520 performs one adaptive gain control at a frontmost position of the signal.

In an exemplary embodiment, the control module 520 is configured to perform multiple adaptive gain controls on the signal in the following manner: in a case where the signal does not include the long-format second-type service scheduling unit, the control module 520 performs adaptive gain controls at start positions of a first part and a second part of the first-type service scheduling unit in the signal, wherein the first-type service scheduling unit includes the first part and the second part, and a time length of the first part or the second part is equal to the time length of the second-type service scheduling unit.

In an exemplary embodiment, the first notification message received by the notification module 610 further includes an indication of whether powers of multiple second-type service scheduling units forming the long-format second-type service scheduling unit are the same.

In an exemplary embodiment, the control module 520 performs multiple adaptive gain controls on the signal in the following manner: in a case where the signal includes the long-format second-type service scheduling unit and the powers of the multiple second-type service scheduling units forming the long-format second-type service scheduling unit are different, the control module 520 performs one adaptive gain control at a frontmost position of the signal, and performs adaptive gain controls at positions where the first-type service scheduling unit and the second-type service scheduling unit with a different power are aligned.

In an exemplary embodiment, the control module 520 is configured to perform one adaptive gain control on the signal in the following manner: in a case where the signal includes the long-format second-type service scheduling unit and powers of the multiple second-type service scheduling units forming the long-format second-type service scheduling unit are the same, the control module 520 performs one adaptive gain control at a frontmost position of the signal.

In an exemplary embodiment, the first notification message received by the notification module 610 further indicates whether virtual data is filled in the long-format second-type service scheduling unit; and in a case where the virtual data is filled in the long-format second-type service scheduling unit, the first notification message further indicates a position of the virtual data and a size of the virtual data.

In practical implementation, in a case where the virtual data is filled in the long-format second-type service scheduling unit, the control module 520 performs one adaptive gain control at the frontmost position of the signal.

It should be noted that each module may be implemented by software or hardware. The latter may be implemented in the following manner, but is not limited thereto. All the modules are located in a same processor; alternatively, the modules are located in different processors in an arbitrary combination.

The embodiments of the present disclosure further provide a computer-readable storage medium. The computer-readable storage medium stores a computer program, and the computer program, when executed by a processor, causes the processor to implement the operations in any one of the described method embodiments.

In an exemplary embodiment, the computer-readable storage medium may include, but is not limited to, any medium that can store a computer program, such as a Universal Serial Bus (USB) flash drive, a Read-Only Memory (ROM), a Random Access Memory (RAM), a mobile hard disk, a magnetic disk, or an optical disc.

The embodiments of the present disclosure further provide an electronic apparatus, including a memory and a processor. The memory stores a computer program. The processor is configured to run the computer program to execute the operations in any one of the method embodiments.

In an exemplary embodiment, the electronic apparatus may further include a transmission device and an input/output device, wherein the transmission device is connected to the processor, and the input/output device is connected to the processor.

Examples in the embodiments of the present disclosure may refer to the examples described in the above embodiments and the exemplary embodiments, which will not be repeated herein.

Obviously, those having ordinary skill in the art should understand that each module or each operation of the above embodiments of the present disclosure can be implemented by a universal computing device, they may be centralized on a single computing device or distributed on a network composed of a plurality of computing devices, they can be implemented by program codes executable by a computing apparatus, and thus can be stored in a storage apparatus and executed by the computing apparatus. Furthermore, in some cases, the shown or described operations may be executed in an order different from that described here, or they are made into integrated circuit modules respectively, or a plurality of modules or operations therein are made into a single integrated circuit module for implementation. As such, the embodiments of the present disclosure are not limited to any particular hardware and software combination.

In order to enable those having ordinary skill in the art to better understand the technical solutions of the embodiments of the present disclosure, descriptions will be given below with reference to scenario-based embodiments.

Scenario-based embodiment 1

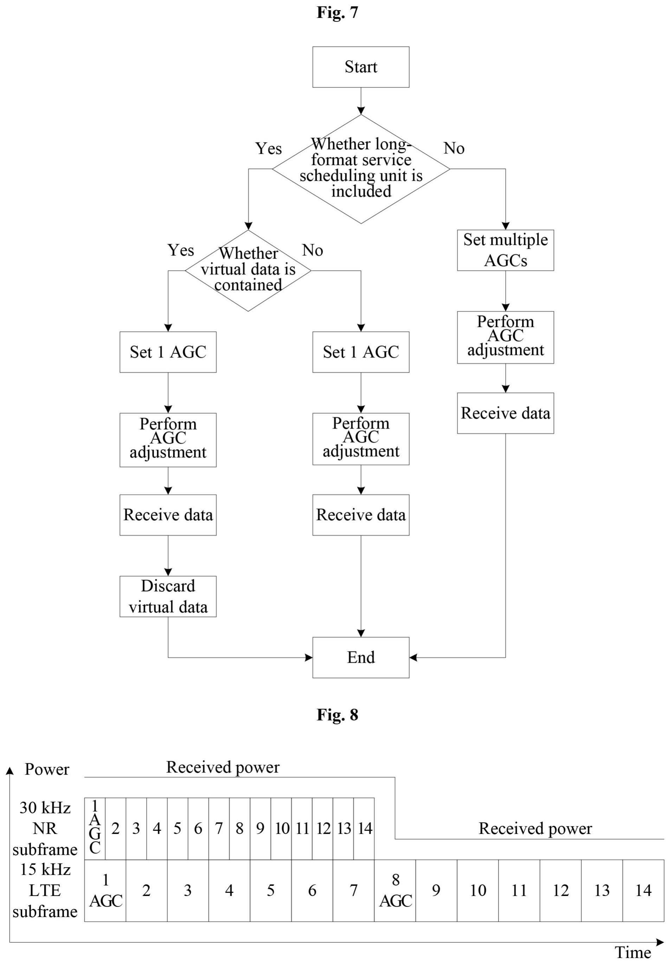

Fig. 7 is a flowchart illustrating the principle of an adaptive gain control method according to an embodiment of the present disclosure. As shown in Fig. 7, initially, it is determined whether a long-format service scheduling unit is included. If a long-format service scheduling unit is not included, and thus it is unable to merge second-type service scheduling units into a long-format second-type service scheduling unit, multiple AGC adjustments are required, and data is received after AGC adjustments. If a long-format service scheduling unit is included, indicating that it is possible to merge second-type service scheduling units into a long-format second-type service scheduling unit, it is then necessary to determine whether virtual data is included. If virtual data is included and used when merging the second-type service scheduling units into the long-format second-type service scheduling unit, the virtual data needs to be discarded after receiving the data.

In an embodiment, when virtual data is included and used when merging the second-type service scheduling units into the long-format second-type service scheduling unit, it indicates that the data to be transmitted does not contain information for merging into the long-format second-type service scheduling unit. That is, the existing data to be transmitted only supports the merging into the long-format second-type service scheduling unit but does not contain data for the merge, thus requiring the filling of virtual data for the merge.

In an embodiment, when a long-format service scheduling unit is not included, multiple AGC adjustments are required. Depending on whether powers of the second-type service scheduling units are different, the setup of AGC also varies, with specific scenarios to be described in subsequent examples.

Fig. 8 is a schematic diagram of AGC adjustment according to an embodiment of the present disclosure. As shown in Fig. 8, the first user equipment performs AGC adjustment at the position of the first OFDM symbol of the subframe, ensuring, through a receive gain X1, that the total received power of the first to the seventh OFDM symbols of the LTE subframe and the first to the fourteenth OFDM symbols of the NR subframe is within the quantization range of the ADC; and the first user equipment performs AGC adjustment at the position of the eighth OFDM symbol of the subframe, ensuring, through a receive gain Y1, that the total received power of the eighth to the fourteenth OFDM symbols of the LTE subframe and the signal from the two types of sending ends, namely the LTE service scheduling unit and the NR service scheduling unit, is within the quantization range of the ADC.

As shown in Fig. 8, in the current scenario-based embodiment, the LTE subframe includes multiple LTE service scheduling units, which are the first-type service scheduling units mentioned in the above embodiments, and the NR subframe includes multiple NR service scheduling units, which are the second-type service scheduling units mentioned in the above embodiments.

As shown in Fig. 8, no merging of the second-type service scheduling units, namely NR service scheduling units, has been performed, nor has virtual data been filled to obtain the long-format NR service scheduling units. Therefore, multiple AGC adjustments are required. In an embodiment, as shown in Fig. 8, one AGC adjustment is performed at the frontmost position, i.e., the first OFDM symbol, of the LTE service scheduling unit, one AGC adjustment is performed at the frontmost position of the NR service scheduling unit, and an additional AGC adjustment is performed at the position of the eighth OFDM symbol, which is the middle position where the LTE service scheduling unit and the NR service scheduling unit are aligned.

In the embodiment of the present disclosure, by setting multiple AGC symbols and maintaining the format of the service scheduling units in the existing system, the receiving end can accurately perform AGC adjustments at positions where the power changes.

### Scenario-based embodiment 2

In the current scenario-based embodiment, the LTE subframe includes multiple LTE service scheduling units, which are the first-type service scheduling units mentioned in the above embodiments, and the NR subframe includes multiple NR service scheduling units, which are the second-type service scheduling units mentioned in the above embodiments.

A similarity between the current scenario-based embodiment and scenario-based embodiment 1 is that no merging of the second-type service scheduling units, namely NR service scheduling units, has been performed, nor has virtual data been filled to obtain the long-format NR service scheduling units. A difference between the current scenario-based embodiment and scenario-based embodiment 1 lies in that the alignment position of the LTE service scheduling unit and the NR service scheduling unit is different, that is, the LTE service scheduling unit in the foregoing embodiment may be divided into a first part and a second part, and the first part or the second part has the same time length as that of the NR service scheduling unit.

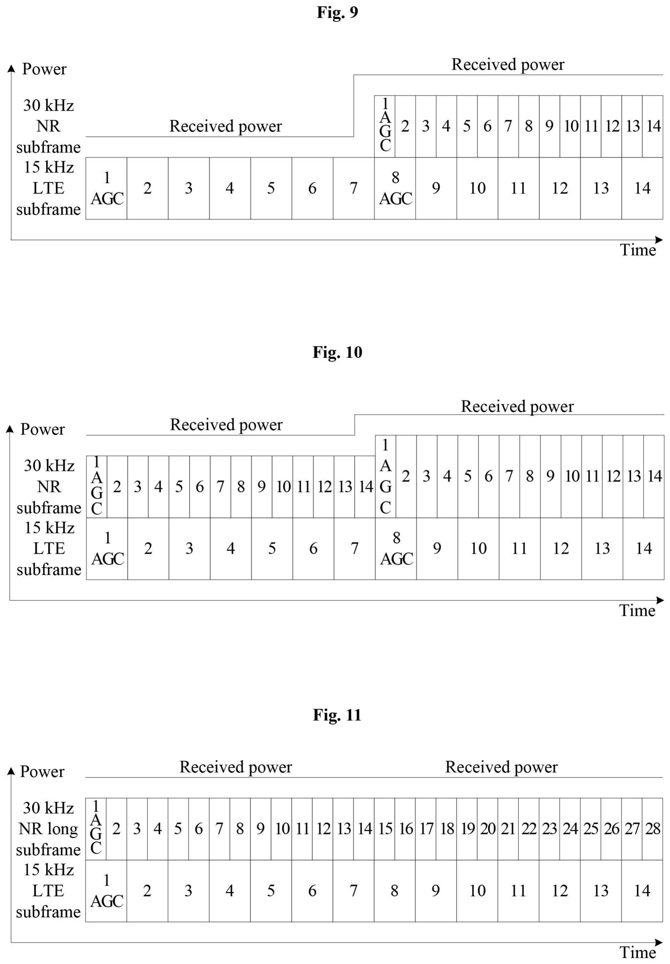

Fig. 9 is a schematic diagram of AGC adjustment according to an embodiment of the present disclosure. As shown in Fig. 9, the first user equipment performs AGC adjustment at the position of the first OFDM symbol of the subframe, ensuring, through a receive gain X2, that the received power of the first to the seventh OFDM symbols of the LTE subframe is within the quantization range of the ADC; and the first user equipment performs AGC adjustment at the position of the eighth OFDM symbol of the subframe ensuring, through a receive gain Y2, that the total received power of the eighth to the fourteenth OFDM symbols of the LTE subframe and the first to the fourteenth OFDM symbols of the NR subframe, is within the quantization range of the ADC.

In the embodiment of the present disclosure, by setting multiple AGC symbols and maintaining the format of the service scheduling units in the existing system, the receiving end can accurately perform AGC adjustments at positions where the power changes.

### Scenario-based embodiment 3

In the current scenario-based embodiment, the LTE subframe includes multiple LTE service scheduling units, which are the first-type service scheduling units mentioned in the above embodiments, and the NR subframe includes multiple NR service scheduling units, which are the second-type service scheduling units mentioned in the above embodiments

Fig. 10 is a schematic diagram of AGC adjustment according to an embodiment of the present disclosure. As shown in Fig. 10, the first user equipment performs AGC adjustment at the position of the first OFDM symbol of the subframe, ensuring, through a receive gain X3, that the total received power of the first to the seventh OFDM symbols of the LTE subframe and the first to the fourteenth OFDM symbols of the NR subframe is within the quantization range of the ADC; and the first user equipment performs AGC adjustment at the position of the eighth OFDM symbol of the subframe, ensuring, through a receive gain Y3, that the total received power of the eighth to the fourteenth OFDM symbols of the LTE subframe and the first to the fourteenth OFDM symbols of the second NR subframe is within the quantization range of the ADC.

As shown in Fig. 10, the received powers of a plurality of NR service scheduling units are different, so it is necessary to perform AGC adjustment at the alignment positions of the NR service scheduling units and the LTE service scheduling units with different received powers. That is, the AGC adjustment is performed at all positions where the power changes.

In the embodiment of the present disclosure, by setting multiple AGC symbols and maintaining the format of the service scheduling units in the existing system, the receiving end can accurately perform AGC adjustments at positions where the power changes.

### Scenario-based embodiment 4

In the current scenario-based embodiment, the LTE subframe includes multiple LTE service scheduling units, which are the first-type service scheduling units mentioned in the above embodiments, and the NR subframe includes multiple NR service scheduling units, which are the second-type service scheduling units mentioned in the above embodiments

In this scenario-based embodiment, a plurality of NR service scheduling units are merged to obtain a long-format NR service scheduling unit.

Fig. 11 is a schematic diagram of AGC adjustment according to an embodiment of the present disclosure. As shown in Fig. 11, the first user equipment performs AGC adjustment at the position of the first OFDM symbol of the subframe, ensuring, through a receive gain X4, that the total received power of the first to the fourteenth OFDM symbols of the LTE subframe and the first to the twenty-eighth OFDM symbols of the long subframe obtained by merging two NR subframes is within the quantization range of the ADC.

In the embodiments of the present disclosure, by merging service scheduling units into a long-format service scheduling unit, excessive power variations are avoided, thereby reducing the number of AGC adjustments performed by the receiving end and reducing the number of AGC symbols.

### Scenario-based embodiment 5

In the current scenario-based embodiment, the LTE subframe includes multiple LTE service scheduling units, which are the first-type service scheduling units mentioned in the above embodiments, and the NR subframe includes multiple NR service scheduling units, which are the second-type service scheduling units mentioned in the above embodiments

In the current scenario-based embodiment, a long-format NR service scheduling unit is also obtained. However, different from the scenario-based embodiment 4, the number of NR service scheduling units from the third user equipment is insufficient to support the merging to obtain the long-format NR service scheduling unit; therefore, in this scenario-based embodiment, virtual data is used to fill in to obtain the long-format NR service scheduling unit.

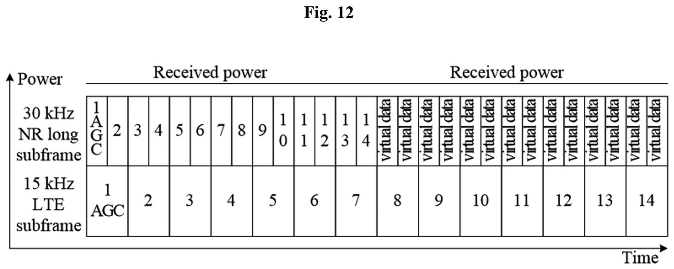

Fig. 12 is a schematic diagram of AGC adjustment according to an embodiment of the present disclosure. As shown in Fig. 12, the first user equipment performs AGC adjustment at the position of the first OFDM symbol of the subframe, ensuring, through a receive gain X5, that the total received power of the first to the fourteenth OFDM symbols of the first LTE subframe and the first to the twenty-eighth OFDM symbols of the long subframe formed by merging two NR subframes is within the quantization range of the ADC, wherein the fifteenth to the twenty-eighth OFDM symbols are virtual data for padding.

In the embodiments of the present disclosure, by merging service scheduling units and virtual data for padding into a long-format service scheduling unit, excessive power variations are avoided, thereby reducing the number of AGC adjustments performed by the receiving end and reducing the number of AGC symbols.

The described scenario-based embodiments 1 to 3 all involve setting AGC within the time range of the service scheduling units, where the first user equipment employs one or multiple adaptive gain controls within the time range of the service scheduling units to meet the need for precise AGC adjustments by the receiving end at locations where power changes occur, ensuring signal quality and, in turn, communication quality..

In scenario-based embodiment 4, N second-type service scheduling units are merged into a long-format second-type service scheduling unit, which has the same length as one first-type service scheduling unit; by merging the service scheduling units into the long-format service scheduling unit, excessive power changes are avoided, reducing the number of AGC adjustments by the receiving end and reducing the number of AGC symbols.

In scenario-based embodiment 5, virtual data is filled to form a long-format second-type service scheduling unit, which has the same length as one first-type service scheduling unit. By merging service scheduling units and filling virtual data to form the long-format service scheduling unit, excessive power changes are avoided, thereby reducing the number of AGC adjustments by the receiving end and reducing the number of AGC symbols. The content of the virtual data is not important and may be any arbitrary number.

The above are only exemplary embodiments of the present disclosure, and are not intended to limit the embodiments of the present disclosure. For those having ordinary skill in the art, the embodiments of the present disclosure may have various modifications and variations. Any modifications, equivalent replacements, improvements and the like made within the principle of the embodiments of the present disclosure shall fall within the scope of protection of the embodiments of the present disclosure.

## Claims

1. An adaptive gain control method, comprising:
receiving, by a first user equipment, a signal from a second user equipment and a third user equipment, wherein the first user equipment communicates with the second user equipment using a first sub-carrier spacing and a first-type service scheduling unit, and the first user equipment communicates with the third user equipment using a second sub-carrier spacing and a second-type service scheduling unit, and the signal comprises the first-type service scheduling unit and the second-type service scheduling unit; and
performing, by the first user equipment, one or multiple adaptive gain controls on the signal.

2. The adaptive gain control method according to claim 1, wherein the second sub-carrier spacing is N times the first sub-carrier spacing, and a time length of the first-type service scheduling unit is N times a time length of the second-type service scheduling unit, wherein N is a positive integer.

3. The adaptive gain control method according to claim 2, wherein before receiving, by the first user equipment, the signal from the second user equipment and the third user equipment, the adaptive gain control method further comprises:
receiving, by the first user equipment, a first notification message from the third user equipment, wherein the first notification message indicates whether the signal comprises a long-format second-type service scheduling unit, wherein the long-format second-type service scheduling unit is formed by merging N second-type service scheduling units, and a time length of the long-format second-type service scheduling unit is equal in the time length of one first-type service scheduling unit.

4. The adaptive gain control method according to claim 3, wherein performing, by the first user equipment, one adaptive gain control on the signal comprises:
in a case where the signal comprises the long-format second-type service scheduling unit, performing, by the first user equipment, one adaptive gain control at a frontmost position of the signal.

5. The adaptive gain control method according to claim 3, wherein performing, by the first user equipment, multiple adaptive gain controls on the signal comprises:
in a case where the signal does not comprise the long-format second-type service scheduling unit, performing, by the first user equipment, adaptive gain controls at start positions of a first part and a second part of the first-type service scheduling unit in the signal, wherein the first-type service scheduling unit comprises the first part and the second part, and a time length of the first part or the second part is equal to the time length of the second-type service scheduling unit.

6. The adaptive gain control method according to claim 3, wherein the first notification message further comprises an indication of whether powers of multiple second-type service scheduling units forming the long-format second-type service scheduling unit are the same.

7. The adaptive gain control method according to claim 6, wherein performing, by the first user equipment, multiple adaptive gain controls on the signal comprises:
in a case where the signal comprises the long-format second-type service scheduling unit and the powers of the multiple second-type service scheduling units forming the long-format second-type service scheduling unit are different, performing, by the first user equipment, one adaptive gain control at a frontmost position of the signal, and performing, by the first user equipment, adaptive gain controls at positions where the first-type service scheduling unit and the second-type service scheduling unit with a different power are aligned.

8. The adaptive gain control method according to claim 6, wherein performing, by the first user equipment, one adaptive gain control on the signal comprises:
in a case where the signal comprises the long-format second-type service scheduling unit and powers of the multiple second-type service scheduling units forming the long-format second-type service scheduling unit are the same, performing, by the first user equipment, one adaptive gain control at a frontmost position of the signal.

9. The adaptive gain control method according to claim 3, wherein the first notification message further indicates whether virtual data is filled in the long-format second-type service scheduling unit, a position of the virtual data, and a size of the virtual data.

10. An adaptive gain control apparatus provided in a first user equipment, wherein the adaptive gain control apparatus comprises:
a communication module, configured to receive a signal from a second user equipment and a third user equipment, wherein the first user equipment communicates with the second user equipment using a first sub-carrier spacing and a first-type service scheduling unit, and the first user equipment communicates with the third user equipment using a second sub-carrier spacing and a second-type service scheduling unit, and the signal comprises the first-type service scheduling unit and the second-type service scheduling unit; and
a control module, configured to perform one or multiple adaptive gain controls on the signal.

11. A computer-readable storage medium, wherein the computer-readable storage medium stores a computer program, and the computer program, when executed by a processor, causes the processor to implement the adaptive gain control method according to any of claims 1 to 9.

12. An electronic apparatus, comprising a memory, a processor, and a computer program stored on the memory and executable by the processor, wherein the processor, when executing the computer program, implements the adaptive gain control method according to any of claims 1 to 9.
